# FASCICULE DE BREVET EUROPEEN

(11) **EP 3 203 138 B1**
(45) Date de publication et mention de la délivrance du brevet: **17.11.2021**
(21) Numéro de dépôt: 17154464.6
(22) Date de dépôt: 02.02.2017
(51) Int. Cl.: F21S 41/19, F21S 43/14, F21S 43/19, F21S 43/20, F21S 43/145, F21S 45/47, F21S 41/153

(54) **DIDPOSITIF D'ECLAIRAGE OU DE DE SIGNALISATION POUR VEHICULE AUTOMOBILE**
BELEUCHTUNGS- ODER SIGNALISIERUNGSVORRICHTUNG FÜR KRAFTFAHRZEUG
LIGHTING OR SIGNALLING DEVICE FOR A MOTOR VEHICLE

(30) Priorité: 04.02.2016 FR 1650878
(43) Date de publication de la demande: 09.08.2017
(73) Titulaire: Valeo Vision, 93012 Bobigny Cedex (FR)
(72) Inventeur: DUARTE, Marc, 93250 Villemomble (FR); MORELLE, Jean-Michel, 45190 Beaugency (FR); ZOJCESKI, Zdravko, 92400 Courbevoie (FR)
(74) Mandataire: Valeo Visibility

(56) Documents cités:
- EP-A2- 1 784 055
- WO-A1-2015/135889
- KR-A- 20120 126 770
- KR-A- 20120 130 409
- US-A1- 2001 031 509
- US-A1- 2003 047 280
- US-A1- 2012 098 449
- US-A1- 2015 054 417
- US-A1- 2015 371 585

## Description

### Domaine technique

La présente invention se rapporte au domaine de l'éclairage et de la signalisation de véhicules, notamment de véhicules automobiles. L'invention concerne plus particulièrement un dispositif d'éclairage ou de signalisation de véhicule automobile.

### Etat de la technique

Il est désormais connu d'utiliser des diodes électroluminescentes ou LEDs (pour Light Emitting Diodes en langue anglaise) dans le domaine automobile pour éclairer, notamment la route, ou se signaler, notamment vis-à-vis des autres véhicules et usagers de la route. Les dispositifs utilisés emploient généralement une pluralité de LEDs montées sur un substrat formant support. Ces LEDs sont disposées sur le substrat de manière à former le motif d'éclairage et/ou de signalisation souhaité.

Les LEDs sont pilotées par au moins un circuit de pilotage disposé à proximité du substrat. Le circuit de pilotage est raccordé à la pluralité de LEDs par un circuit de liaison électrique est connecté par une technologie de montage en surface (ou SMT pour Surface-Mounted Technology en langue anglaise).

Actuellement, les dimensions du substrat sont imposées, non pas directement par le nombre de LEDs à monter sur le substrat car il est maintenant possible de réaliser des LEDs de très petite taille, mais par les dimensions de la zone de connexion entre le circuit de liaison électrique et le substrat.

La technologie actuelle de montage en surface (SMT) impose un pas (ou "pitch" en langue anglaise) entre deux points de connexion adjacents de l'ordre de 0,3 mm à 0,5 mm, ce qui limite la densité d'interconnexion entre le circuit de liaison électrique et le substrat.

Le document US2015054417 décrit un dispositif lumineux de véhicule automobile comprenant un substrat diélectrique comportant une pluralité de pistes conductrices, une pluralité de diodes électroluminescentes montées en surface sur ledit substrat diélectrique, les diodes électroluminescentes étant connectées électriquement aux pistes conductrices du substrat diélectrique selon un plan de connexion prédéterminé, au moins un circuit de pilotage pour piloter les diodes électroluminescentes, et un circuit de liaison électrique comportant une pluralité de lignes conductrices pour relier électriquement les broches de connexion du circuit de pilotage aux pistes conductrices du substrat diélectrique selon un plan de connexion prédéterminé.

Il est connu de KR20120126770 un dispositif d'affichage dans lequel un panneau à cristaux liquides est connecté à un dispositif de pilotage au moyen d'un film conducteur anisotrope.

Il est par ailleurs connu de US2003047280 un dispositif lumineux à source OLED dont un circuit de pilotage est connecté à un circuit imprimé flexible via un film conducteur anisotrope.

Le document US2001031509 divulgue un dispositif lumineux à source OLED pixellisée dont un circuit de pilotage est relié à des circuit intégrés de différentes sortes via un film conducteur anisotrope.

Le document KR20120130409 enseigne quant à lui un film conducteur anisotrope permettant de résoudre plusieurs problèmes de fiabilité de tels films.

Il est connu de EP1784055 un dispositif selon le préambule de la revendication 1.

Il est connu de US2012098449 et de WO2015135889 un dispositif lumineux dans lequel un film conducteur anisotrope réalise des électrodes sur un film électroluminescent de type OLED.

Enfin, il est connu de US2015371585 un dispositif lumineux de véhicule automobile comprenant un substrat diélectrique comportant une pluralité de pistes conductrices, une pluralité de diodes électroluminescentes montées en surface sur ledit substrat diélectrique, les diodes électroluminescentes étant connectées électriquement aux pistes conductrices du substrat diélectrique selon un plan de connexion prédéterminé, un circuit de pilotage pour piloter les diodes électroluminescentes, et un circuit de liaison électrique comportant une pluralité de lignes conductrices pour relier électriquement les broches de connexion du circuit de pilotage aux pistes conductrices du substrat diélectrique selon un plan de connexion prédéterminé, le circuit de liaison électrique étant connecté aux pistes conductrices du substrat diélectrique via un film conducteur anisotrope.

### Résumé de l'invention

Un objet de l'invention est de proposer un dispositif d'éclairage ou de signalisation comportant une pluralité de diodes luminescentes montées sur un substrat ayant une surface réduite.

Un autre objet de l'invention est de proposer un dispositif d'éclairage ou de signalisation qui soit facile à réaliser.

Selon l'invention, il est proposé de raccorder le circuit de liaison électrique au substrat par un film conducteur anisotrope (ou ACF pour Anisotropic Conductive Film en langue anglaise) de manière à réduire fortement le pas entre les points de connexion.

Ainsi, l'invention concerne un dispositif lumineux de véhicule automobile, notamment d'éclairage et/ou de signalisation de véhicule automobile, comprenant:
- un substrat diélectrique comportant une pluralité de pistes conductrices,
- une pluralité de diodes électroluminescentes montées en surface sur ledit substrat diélectrique, les diodes électroluminescentes étant connectées électriquement aux pistes conductrices du substrat diélectrique selon un plan de connexion prédéterminé,
- au moins un circuit de pilotage pour piloter les diodes électroluminescentes, ledit circuit de pilotage comportant une pluralité de broches de connexion, et
- un circuit de liaison électrique comportant une pluralité de lignes conductrices pour relier électriquement les broches de connexion du circuit de pilotage aux pistes conductrices du substrat diélectrique selon un plan de connexion prédéterminé, remarquable en ce que le circuit de liaison électrique est connecté aux pistes conductrices du substrat diélectrique via un film conducteur anisotrope.

L'emploi d'un film conducteur anisotrope permet de réduire le pas entre les points de connexion au niveau de la liaison entre le substrat et le circuit de liaison électrique. On peut alors obtenir un pas compris entre 0,035 et 0,200 mm. La zone de connexion du circuit de liaison électrique au substrat est alors réduite. On peut ainsi intégrer un plus grand nombre de LEDs sans augmenter la taille du substrat ou diminuer la taille du substrat tout en conservant le même nombre de LEDs.

Selon un mode de réalisation particulier, le film conducteur anisotrope comporte une pluralité de chemins de conduction électrique, le pas entre deux chemins de conduction adjacents étant compris entre 0,035 et 0,200 mm.

Selon un mode de réalisation particulier, le circuit de liaison électrique est un circuit intégré flexible.

Selon un mode de réalisation particulier, le substrat diélectrique est monté sur un circuit de dissipation thermique.

Selon un mode de réalisation particulier, le substrat diélectrique est en matériau céramique.

Selon un mode de réalisation particulier, le substrat diélectrique comporte du nitrure d'aluminium.

Selon un mode de réalisation particulier, le film conducteur anisotrope comporte une couche de matériau adhésif et des billes conductrices, lesquelles billes conductrices sont agglomérées entre elles dans ladite couche de matériau adhésif de manière à former lesdits chemins de conduction.

Selon un mode de réalisation particulier, les billes conductrices (41) sont de billes de plastique recouverte de nickel, d'or ou d'un mélange d'or et de nickel.

D'autres avantages pourront encore apparaître à l'homme du métier à la lecture des exemples ci-dessous, illustrés par les figures annexées, donnés à titre illustratif.

### Brève description des figures

- La figure 1 représente une vue de dessus partielle d'un dispositif conforme à l'invention; et
- La figure 2 représente une vue agrandie en coupe transversale du dispositif de la figure 1.

### Description détaillée de l'invention

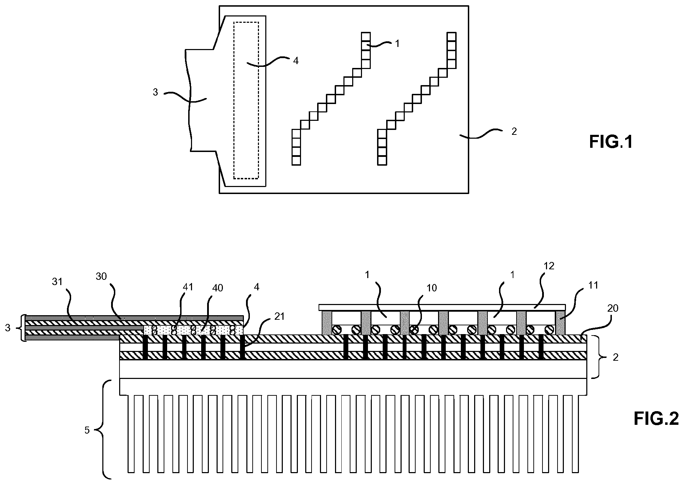

En référence aux figures 1 et 2, le dispositif de l'invention comporte une matrice de diodes électroluminescentes ou LEDs 1 montées en surface sur un substrat diélectrique 2. Les diodes sont disposées sur le substrat de manière à former le motif lumineux d'éclairage ou de signalisation souhaité.

Le substrat diélectrique 2 est avantageusement en matériau céramique et comporte une pluralité de pistes conductrices (ou métalliques) réparties sur une ou 2 couches métalliques selon le nombre de diodes 1 du motif lumineux. Dans l'exemple illustré, le substrat diélectrique 2 est à base de nitrure d'aluminium (AlN) et comporte deux couches métalliques 20 comme illustré sur la figure 2. Des vias 21, en cuivre ou en tungstène, sont prévus pour relier entre elles des pistes métalliques appartenant à deux couches métalliques distinctes.

L'anode et la cathode des LEDs 1 sont connectées aux pistes métalliques du substrat par soudure, par collage ou autres moyens d'assemblage. Dans l'exemple illustré, l'anode et la cathode des LEDs sont connectées aux pistes métalliques du substrat par des billes 10 en Nickel et or (NiAu) selon un plan de connexion prédéterminé.

Des cloisons 11 sont disposées entre les LEDs 1 pour réfléchir la lumière vers l'extérieur. Ces cloisons sont par réalisées en un matériau comprenant du dioxyde de titane (TiO₂) et du silicium (Si).

La matrice de LEDs est par ailleurs recouverte par une couche de luminophore 12 pour convertir la lumière colorée produite par les LEDs en une lumière de couleur blanche. Un luminophore désigne un convertisseur de lumière comprenant au moins un matériau luminescent conçu pour absorber au moins une partie d'au moins une lumière d'excitation émise par une source lumineuse et pour convertir au moins une partie de ladite lumière d'excitation absorbée en une lumière d'émission ayant une longueur d'onde différente de celle de la lumière d'excitation. Dans le cas d'une lumière jaune, le matériau du luminophore est par exemple l'un des composants suivants: Y₃A₁₅O₁₂ : Ce³⁺ (YAG), (Sr,Ba)₂SiO₄:Eu²⁺, Caₓ(Si,Al)₁₂(O,N)₁₆:Eu²⁺

Le dispositif de l'invention comporte en outre un ou plusieurs circuits de pilotage non représenté(s) sur les figures pour piloter les LEDs. Ce circuit de pilotage est connecté au substrat 2 via un circuit de liaison électrique 3. Ce circuit de liaison est avantageusement un circuit intégré flexible comportant une pluralité de pistes conductrices réparties sur une ou plusieurs couches métalliques 31 montées sur un substrat diélectrique 30.

Ce circuit de liaison 3 est destiné à relier électriquement des broches de connexion du ou des circuits de pilotage aux pistes métalliques du substrat 2 selon un plan de connexion prédéterminé.

Selon un aspect important de l'invention, les pistes conductrices du circuit de liaison 3 sont connectées aux pistes conductrices du substrat 2 via un film conducteur anisotrope 4 (ou film ACF pour Anisotropic Conductive Film en langue anglaise). Comme représenté sur la figure 2, le film ACF 4 est interposé entre le circuit de liaison 3 et le substrat 2.

Ce film ACF 4 comprend une couche de matériau adhésif 40 dans laquelle sont présentes des billes 41 conductrices. Les billes sont par exemple des billes de plastique recouverte de nickel et/ou d'or ayant un diamètre de 10 µm. Le film ACF employé est par exemple le film référencé CP801AM-35AC ou CP801AM-45AC commercialisé par la société Dexerials. Ce film ACF se comporte comme une bande adhésive double face, l'une des faces du film ACF 4 étant collée à une face du circuit de liaison 3 et l'autre face étant collée à une face du substrat 2.

Les billes conductrices 41 sont agglomérées entre elles en chauffant le film ACF à une température comprise entre 150°C et 200°C et en appliquant une pression de l'ordre de 2 à 4 MPa de manière à former des chemins de conduction électrique (ou chemins de courant) selon une direction sensiblement verticale aux endroits où la pression est appliquée.

La section des chemins de conduction et le pas entre ces chemins de conduction peut être réduit en raison du faible diamètre des billes conductrices (10 µm). On peut ainsi obtenir un pas entre chemins de conduction adjacents compris entre 0,035 et 0,200 mm.

On peut ainsi réduire la taille de la zone de connexion du circuit de liaison électrique 3 au substrat 2. De ce fait, il est alors possible d'augmenter le nombre de LEDs sur le substrat sans augmenter la taille de ce dernier ou de réduire la taille du substrat en conservant le même nombre de LEDs.

Avantageusement, le substrat 2 est monté sur un circuit de dissipation thermique 5 pour éviter l'échauffement du substrat lorsque les LEDs sont allumés. Chaque LED (= 1 pixel) est par exemple commandé par le circuit de pilotage avec un courant de l'ordre de 120 mA sous une tension de 3,3 volts, soit une puissance de 400 mW environ (40 lumens).

## Revendications

1. Dispositif lumineux de véhicule automobile, notamment d'éclairage et/ou de signalisation, comprenant:
- un substrat diélectrique (2) comportant une pluralité de pistes conductrices,
- une pluralité de diodes électroluminescentes (1) montées en surface sur ledit substrat diélectrique, les diodes électroluminescentes étant connectées électriquement aux pistes conductrices du substrat diélectrique selon un plan de connexion prédéterminé,
- au moins un circuit de pilotage pour piloter les diodes électroluminescentes, ledit circuit de pilotage comportant une pluralité de broches de connexion, et
- un circuit de liaison électrique (3) comportant une pluralité de lignes conductrices pour relier électriquement les broches de connexion du circuit de pilotage aux pistes conductrices du substrat diélectrique selon un plan de connexion prédéterminé,
le circuit de liaison électrique (3) étant connecté aux pistes conductrices du substrat diélectrique (2) via un film conducteur anisotrope (4), **caractérisé en ce que**
le substrat diélectrique (2) est monté sur un circuit de dissipation thermique (5),
et **en ce que** des cloisons (11) sont disposées entre les diodes électroluminescentes (1) pour réfléchir la lumière émise par les diodes électroluminescentes vers l'extérieur.

2. Dispositif lumineux selon la revendication 1, **caractérisé en ce que** le film conducteur anisotrope (4) comporte une pluralité de chemins de conduction électrique, le pas entre deux chemins de conduction adjacents étant compris entre 0,035 et 0,200 mm.

3. Dispositif lumineux selon la revendication 1 ou 2, **caractérisé en ce que** le circuit de liaison électrique (3) est un circuit intégré flexible.

4. Dispositif lumineux selon l'une quelconque des revendications précédentes, **caractérisé en ce que** le substrat diélectrique (2) est en matériau céramique.

5. Dispositif lumineux selon la revendication 4, **caractérisé en ce que** le substrat diélectrique comporte du nitrure d'aluminium.

6. Dispositif lumineux selon l'une quelconque des revendications 2, 4 ou 5, **caractérisé en ce que** le film conducteur anisotrope (4) comporte une couche de matériau adhésif (40) et des billes conductrices (1), lesquelles billes conductrices sont agglomérées entre elles dans ladite couche de matériau adhésif de manière à former lesdits chemins de conduction.

7. Dispositif lumineux selon la revendication 6, **caractérisé en ce que** les billes conductrices (41) sont de billes de plastique recouverte de nickel, d'or ou d'un mélange d'or et de nickel.

## Patentansprüche

1. Beleuchtungsvorrichtung eines Kraftfahrzeugs, insbesondere zur Beleuchtung und/oder zur Signalisierung, die Folgendes beinhaltet:
- ein dielektrisches Substrat (2), das eine Vielzahl von Leiterbahnen umfasst,
- eine Vielzahl von Elektrolumineszenzdioden (1), die auf dem dielektrischen Substrat oberflächenmontiert sind, wobei die Elektrolumineszenzdioden gemäß einem vorgegebenen Anschlussplan elektrisch an die Leiterbahnen des dielektrischen Substrats angeschlossen sind,
- mindestens eine Steuerschaltung zum Steuern der Elektrolumineszenzdioden, wobei die Steuerschaltung eine Vielzahl von Anschlussstiften umfasst, und
- eine elektrische Verbindungsschaltung (3), die eine Vielzahl von leitfähigen Leitungen umfasst, um die Anschlussstifte der Steuerschaltung gemäß einem vorgegebenen Anschlussplan mit den Leiterbahnen des dielektrischen Substrats zu verbinden,
wobei die elektrische Verbindungsschaltung (3) mittels einer anisotropen leitfähigen Folie (4) an die Leiterbahnen des dielektrischen Substrats (2) angeschlossen ist,
**dadurch gekennzeichnet, dass** das dielektrische Substrat (2) auf einer Wärmesenkenschaltung (5) montiert ist und dass zwischen den Elektrolumineszenzdioden (1) Trennwände (11) angeordnet sind, um das von den Elektrolumineszenzdioden emittierte Licht nach außen zu reflektieren.

2. Beleuchtungsvorrichtung nach Anspruch 1, **dadurch gekennzeichnet, dass** die anisotrope leitfähige Folie (4) eine Vielzahl von elektrischen Leitungspfaden umfasst, wobei der Abstand zwischen zwei benachbarten Leitungspfaden zwischen 0,035 und 0,200 mm liegt.

3. Beleuchtungsvorrichtung nach Anspruch 1 oder 2, **dadurch gekennzeichnet, dass** die elektrische Verbindungsschaltung (3) eine flexible integrierte Schaltung ist.

4. Beleuchtungsvorrichtung nach einem der vorhergehenden Ansprüche, **dadurch gekennzeichnet, dass** das dielektrische Substrat (2) aus einem keramischen Material ist.

5. Beleuchtungsvorrichtung nach Anspruch 4, **dadurch gekennzeichnet, dass** das dielektrische Substrat Aluminiumnitrid umfasst.

6. Beleuchtungsvorrichtung nach einem der Ansprüche 2, 4 oder 5, **dadurch gekennzeichnet, dass** die anisotrope leitfähige Folie (4) eine Schicht aus einem Klebematerial (40) und leitfähige Kugeln (1) umfasst, wobei sich die leitfähigen Kugeln in der Klebematerialschicht zusammenballen, um die Leitungspfade zu bilden.

7. Beleuchtungsvorrichtung nach Anspruch 6, **dadurch gekennzeichnet, dass** die leitfähigen Kugeln (41) Kunststoffkugeln sind, die mit Nickel, Gold oder einer Mischung aus Gold und Nickel überzogen sind.

## Claims

1. Motor vehicle light device, notably for lighting and/or signalling, comprising:
- a dielectric substrate (2) comprising a plurality of conductive tracks,
- a plurality of light-emitting diodes (1) surface-mounted on said dielectric substrate, the light-emitting diodes being connected electrically to the conductive tracks of the dielectric substrate according to a predetermined connection plan,
- at least one driver circuit for driving the light-emitting diodes, said driver circuit comprising a plurality of connection leads, and
- an electrical link circuit (3) comprising a plurality of conductive lines for electrically linking the connection leads of the driver circuit to the conductive tracks of the dielectric substrate according to a predetermined connection plan,
the electrical link circuit (3) being connected to the conductive tracks of the dielectric substrate (2) via an anisotropic conductive film (4),
**characterized in that** the dielectric substrate (2) is mounted on a heat-sink circuit (5), and **in that** partitions (11) are disposed between the light-emitting diodes (1) to reflect the light emitted by the light-emitting diodes to the outside.

2. Light device according to Claim 1, **characterized in that** the anisotropic conductive film (4) comprises a plurality of electrical conduction paths, the pitch between two adjacent conduction paths being between 0.035 and 0.200 mm.

3. Light device according to Claim 1 or 2, **characterized in that** electrical link circuit (3) is a flexible integrated circuit.

4. Light device according to any one of the preceding claims, **characterized in that** the dielectric substrate (2) is made of ceramic material.

5. Light device according to Claim 4, **characterized in that** the dielectric substrate comprises aluminium nitride.

6. Light device according to any one of Claims 2, 4 and 5, **characterized in that** the anisotropic conductive film (4) comprises a layer of adhesive material (40) and conductive balls (1), which conductive balls are bonded together in said layer of adhesive material so as to form said conduction paths.

7. Light device according to Claim 6, **characterized in that** the conductive balls (41) are balls of plastic covered with nickel, gold or a mix of gold and nickel.
